Europäisches Patentamt

European Patent Office

Office européen des brevets

(19)

(11) Publication number : **0 030 216 B2**

(12) # NEW EUROPEAN PATENT SPECIFICATION

(45) Date of publication of the new patent specification : **17.07.91 Bulletin 91/29**

(51) Int. Cl.⁵ : **D06F 3.7/30, H03K 17/965**

(21) Application number : **80830086.7**

(22) Date of filing : **24.10.80**

(54) **Washing machine basket positioning device.**

(30) Priority : **29.10.79 IT 6909979**

(43) Date of publication of application :
**10.06.81 Bulletin 81/23**

(45) Publication of the grant of the patent :
**16.10.85 Bulletin 85/42**

(45) Mention of the opposition decision :
**17.07.91 Bulletin 91/29**

(84) Designated Contracting States :
**BE DE FR GB NL**

(56) References cited :
DE-A- 2 515 792
DE-A- 2 516 905
DE-A- 2 713 035
DE-B- 1 585 953
DE-B- 2 214 635
DE-B- 2 629 128
DE-C- 1 956 272

(56) References cited :
DE-C- 2 028 520
DE-C- 2 502 246
DE-U- 6 603 447
DE-U- 6 603 508
FR-A- 1 526 873
FR-A- 2 364 286
FR-A- 2 442 291
FR-B- 1 526 873
US-A- 3 529 450

(73) Proprietor : **MERLONI ELETTRODOMESTICI
S.p.A.**
**Viale Aristide Merloni, 45**
**I-60044 Fabriano (AN) (IT)**

(72) Inventor : **Galeotti, Massimo**
**Via Nizza, 113**
**I-10126 Torino (IT)**
Inventor : **Fancelli, Fabio**
**Via Torino, 85**
**I-10024 Moncalieri (Torino) (IT)**
Inventor : **Bertagni, Quirino**
**Via Puccini, 3**
**I-10045 Piossasco (Torino) (IT)**

EP 0 030 216 B2

## Description

The present invention relates to a device for positioning the basket of a top-loading washing machine of the type defined in the preamble of claim 1.

A problem with top-loading washing machines is that, after washing or if the machine is stopped during the wash cycle for loading additional items, the basket must be positioned so that the opening is at the top. This can be done manually but is an awkward operation in that the weight is usually unevenly distributed causing the basket to resist rotation.

This problem has been partially overcome by means of devices of the above specified kind, such as that disclosed in FR-A-2364286.

This prior document discloses a device by which when the wash cycle is over, the user can make the basket rotate slowly by pressing a push switch which controls an electronic speed regulator of the motor which drives the basket. As soon as the user, looking through the port or opening of the machine, sees that the basket has reached the desired position, he releases the push switch and the basket stops.

This known device can be dangerous for the user when the operation is carried out with the port open. Further it is quite difficult to obtain accurate positioning of the basket since to achieve this a quite exceptional speed of reaction of the user is required.

The problem of bringing the basket a top-loading washing machine to a halt in a predetermined position has been also discussed in DE-U-6603447.

The object of the present invention is to provide a device, by which the inconveniences of the prior devices can be overcome. This object is achieved according to the invention by means of a device of the above specified kind, characterised in Claim 1.

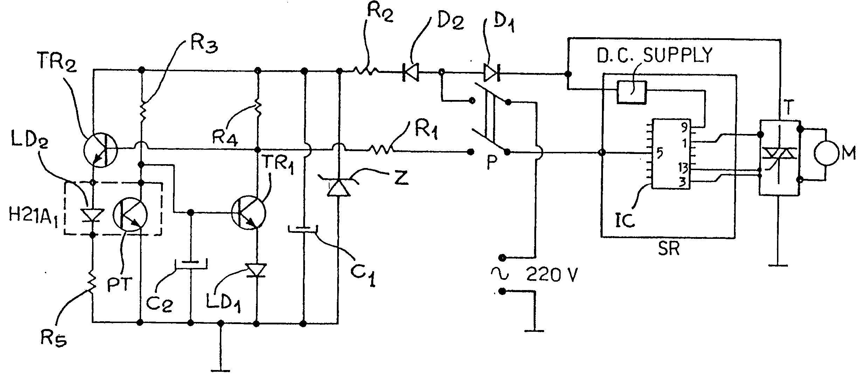

The invention will now be described in detail with reference to the attached drawing, provided by way of a non-limiting example and showing a partial block diagram of the electric circuit on a washing machine according to the present invention.

The letter M in the Figure represents the motor for turning the basket, T a Triac for controlling the speed of the motor and SR a speed control unit which controls the speed of the motor via the said Triac. The said control unit comprises a DC SUPPLY circuit and a Motorola Semiconductors TDA 1085 integrated circuit IC.

Further details concerning the integrated circuit IC and its application can be found in the Motorola Preliminary Information N° 3 publication, August 1978, relative to the TDS 1085.

The 220V a.c. main voltage is supplied to the two terminals marked ~220V in the Figure. P represents a 2-way push-button switch. When the button is pressed, one way connects one main terminal to the anodes of two diodes $D_1$, $D_2$ while the other connects one end of a resistor $R_1$ to pin 5 of IC. The cathode of diode $D_1$ is connected both to the supply circuit of unit SR and to Triac T. To the cathode of the other diode $D_2$ it is connected via a 5.6 Kohm resistor $R_2$ the parallel of a 10 μF condenser $C_1$ and a diode Z.

The condenser $C_1$ supplies the electronic circuit of the device and is connected :
via a 100 Kohm resistor $R_3$, to the collector of a phototransistor PT of a H21A1 unit (General Electric photo-electric coupler) ;
via a 1 Kohm resistor $R_4$, to the collector of a transistor $TR_1$ ;
directly to the collector of a transistor $TR_2$.

The collector of the phototransistor PT is also connected to a 1 μF condenser $C_2$ and the base of transistor $TR_1$. The collector of the same transistor is also connected to the base of the transistor $TR_2$ and the other end of resistor R. The emitter of the transistor $TR_1$ is grounded via a first light-emitting diode $LD_1$. The emitter of transistor $TR_2$ is grounded via a second light-emitting diode $LD_2$ (of the H21A1 unit) and a further 1 Kohm resistor $R_5$ connected in series.

The circuit described operates as follows :

With the machine off (at the end of the cycle or stopped by the operator), the operator presses button P.

Voltage is supplied via diodes $D_1$, $D_2$ to IC, the Triac and the automatic electronic positioning circuit. As the 1 μF condenser $C_2$ is discharged, transistor $TR_1$ is disabled and its collector voltage high ; transistor $TR_2$ is saturated so that the second light-emitting diode $LD_2$ is on ; the phototransistor PT is saturated with low collector voltage and the 1 μF condenser $C_2$ remains discharged. Via resistor $R_1$ current is supplied to pin 5 of IC. This current is such that the motor, together with the basket, starts turning slowly. The basket is fitted mechanically with a cam with a stick-out section which, when the opening of the basket is at the top, intercepts the ray of light between the second light-emitting diode $LD_2$ and the phototransistor PT.

At this stage, the phototransistor PT is disabled and the 1 μF condenser $C_2$ is charged to about 1.2V. Transistor $TR_1$ is then saturated and its collector voltage falls. The first light-emitting diode, $LD_1$, comes on and the motor stops whereas transistor $TR_2$ is disabled and the second light-emitting diode $LD_2$ goes off.

The circuit remains in this condition until the operator, seeing the light of diode $LD_1$, releases button P. This cuts off supply to the circuit so that the 100 μF condenser $C_1$ discharges into transistor $TR_1$ until the 1 μF condenser $C_2$ is also discharged. The circuit is now in the initial operating condition.

If, however, button P is pressed again (with the basket opening at the top), diode $LD_1$ comes on immediately and the basket stays still. This is because the stick-out on the cam continues to intercept the ray of light thus disabling the phototransistor.

The advantages of the present invention will be clear from the description given.

In particular, the operator does not need to see the basket or calculate the exact time to release the push-button when the basket opening reaches the top.

## Claims

1. Device for positioning the basket of a top-loading washing machine, comprising an electronic speed regulator (SR) for controlling the speed of rotation of the eletric motor (M) used to drive the basket, manually operable push-button switch means (P) which, when activated, enables the basket to rotate slowly by providing an appropriate reference voltage to the said electronic speed regulator (SR), characterised in that it further comprises :
electric sensor means (LD$_2$, PT) for producing a stop signal when the basket has reached a desired position,
an electronic control circuit (TR$_1$, TR$_2$ ; C$_1$, C$_2$ ; R$_3$, R$_4$; LD$_1$) connected to the electric sensor means (LD$_2$, PT) and to the said manually operable switch means (P), for stopping the electric motor (M) of the basket in response to said stop signal and for preventing any further activation of the said electric motor (M) before the said manually operable switch means (P) have been deactivated ; and in that the device is arranged so as to be operable when the port of the machine is closed.

2. Device according to Claim 1, characterised in that the said electronic control circuit (TR$_1$, TR$_2$ ; C$_1$, C$_2$ ; R$_3$, R$_4$ ; LD$_1$) is connected to the said sensor means (LD$_2$, PT), the switch means (P) and the electronic speed regulator (SR) and is capable of assuming
a first stable condition in response to the activation of the said switch means (P), for allowing the motor (M) to be stopped, and
a second stable condition in response to the said stop signal, in which it prevents any further activation of the said electric motor (M) before the switch means (P) have been deactivated.

3. Device according to Claim 1 or 2, characterised in that said sensor means comprise an electric light-emitting device (LD$_2$), a device connected to the basket for intercepting the light ray and a photosensitive electric device (PT).

4. A device according to any of the preceding claims, characterised by the fact that it also comprises an optical indicator (LD$_1$) to be activated when the basket is stopped.

5. Device according any of the preceding claims, characterised in that it comprises a resistor (R$_3$) connected to an electric capacitor (C$_2$) so as to form an integrator circuit for introducing a predetermined delay between the said stop signal and the deactivation of the motor (M) which drives the basket.

6. Device according to Claim 4 or 5, characterised in that the power supply to said optical indicator (LD$_1$) is controlled by the said sensor means (LD$_2$, PT) ; the sensor means determining the cut-off of the power supply to the optical indicator (LD$_1$) when the basket has reached the said predetermined position.

7. Device according to Claim 6, characterised in that said electric light-emitting device is a light-emitting diode (LD$_2$) and that said photosensitive electric device is a phototransistor (PT) coupled to the light-emitting diode (LD$_2$).

8. Device according to Claim 6, characterised in that, for controlling the power supply to said optical indicator (LD$_1$) a transistor (TR$_1$) is provided which has the control electrode connected to the output of said sensor means (LD$_2$, PT) for disabling or enabling the power supply to the optical indicator (LD$_1$) depending upon whether the basket has yet or not yet reached the said predetermined position after the manually operable switch means (P) has been activated.

## Patentansprüche

1. Einrichtung zum Positionieren der Trommel einer Toplader-Waschmaschine, mit einem elektronischen Geschwindigkeitsregler (SR) zum Regeln der Umdrehungsgeschwindigkeit des die Trommel antreibenden Elektromotors (M), einer von Hand betätigbaren Drucknopf-Schaltvorrichtung (P), die bei Betätigung die Trommel in die Lage versetzt, sich langsam zu drehen, indem dem elektronischen Geschwindigkeitsregler (SR) eine geeignete Bezugsspannung zugeführt wird, dadurch gekennzeichnet, daß außerdem vorgesehen sind :
eine elektrische Sensoreinrichtung (LD$_2$, PT) zum Erzeugen eines Stopsignals, wenn die trommel eine gewünschte Stellung erreicht hat,
eine elektronische Steuerschaltung (TR$_1$, TR$_2$, C$_1$, C$_2$; R$_3$, R$_4$ ; LD$_1$), die an die elektrische Sensoreinrichtung (LD$_2$, PT) und an die von Hand betätigbare Schaltvorrichtung (P) angeslossen ist, um den Elektromotor (M) zu der Trommel ansprechend auf das Sotsignal anzuhalten und jegliche weitere Aktivierung des Elektromotors (M) zu verhindern, bevor die von Hand betätigbare Schaltvorrichtung (P) deaktiviert ist ; und daß die Einrichtung derartig angeordnet ist, daß ihre Betätigung bei geschlossener Maschinentür möglich wird.

2. Einrichtung nach Anspruch 1, dadurch gekennzeichnet, daß die elektronische Steuerschaltung (TR$_1$, TR$_2$, C$_1$, C$_2$ ; R$_3$, R$_4$ ; LD$_1$) an die Sensoreinrichtung (LD$_2$, PT), die Schaltvorrichtung (P) und den elektronischen Geschwindigkeitsregler (SR) angeschlossen ist und in der Lage ist, ansprechend auf das Aktivieren der Schaltvorrichtung (P) einen ersten stabilen Zustand einzunehmen, damit der Motor (M) angehalten werden kann, und ansprechend auf das Stopsignal einen zweiten stabilen Zustand einzunehmen, in welchem sie jegliche weitere Aktivierung des Elektromotors (M) verhindert, bevor die Schaltvorrichtung (P) deaktiviert ist.

3. Einrichtung nach Anspruch 1 oder 2, dadurch gekennzeichnet, daß die Sensoreinrichtung ein elektrisches lichtemittierendes Bauelement (LD$_2$), ein mit der Trommel verbundenes Bauelement zum Unterbrechen des Lichtstrahls und ein photoempfindliches elektrisches Bauelement (PT) aufweist.

4. Einrichtung nach irgendeinem der vorhergehenden Ansprüche, dadurch gekennzeichnet, daß außerdem, eine optische Anzeige (LD$_1$) vorgesehen ist, die aktiviert wird, wenn die Trommel angehalten ist.

5. Einrichtung nach irgendeinem der vorhergehenden Ansprüche, dadurch gekennzeichnet, daß sie einen an einen elektrischen Kondensator (C$_2$) angeschlossen Widerstand (R$_3$) aufweist, wodurch eine Integratorschaltung gebildet wird, um eine vorbestimmte Verzögerung zwischen dem Stopsignal und dem Deaktivieren des die Trommel antreibenden Motors (M) einzufügen.

6. Einrichtung nach Anspruch 4 oder 5, dadurch gekennzeichnet, daß die Spannungsversorgung der optischen Anzeige (LD$_1$) von der Sensoreinrichtung (LD$_2$, PT) gesteuret wird, wobei die Sensoreinrichtung das Abtrennen der Spannungsversorgung von der optischen Anzeige (LD$_1$) festlegt, wenn die Trommel die vorbestimmte Stellung erreicht hat.

7. Einrichtung nach Anspruch 6, dadurch gekennzeichnet, daß das elektrische lichtemittierende Bauelement eine lichtemittierende Diode (LD$_2$) ist, und daß photoempfindliche elektrische Bauelement ein an die lichtemittierende Diode (LD$_2$) gekoppelter Phototransistor (PT) ist.

8. Einrichtung nach Anspruch 6, dadurch gekennzeichnet, daß zum Steuern der Spannungsversorgung für die optische Anzeige (LD$_1$) ein Transistor (TR$_1$) vorgesehen ist, der mit seiner Steuerelektrode an den Ausgang der Sensoreinrichtung (LD$_2$, PT) angeschlossen ist, um die Spannungsversorgung für die optische Anzeige (LD$_1$) abhängig davon einzuschalten oder auszuschalten, ob die Trommel die vorbestellte Stellung nach Aktivieren der handbetätigbaren Schaltvorrichtung (P) erreicht hat oder nicht.

## Revendications

1. Dispositif de positionnement du panier d'une machine à laver à chargement par dessus, comprenant un régulateur électronique de vitesse (SR) pour commander la vitesse de rotation du moteur électrique (M) utilisé pour entraîner le panier, un moyen commutateur à bouton poussoir actionnable manuellement (P) qui, lorsqu'il est activé permet au panier de tourner lentement en fournissant une tension de référence appropriée audit régulateur électronique de vitesse (SR), caractérisé en ce qu'il comprend en outre :

des moyens détecteurs électriques (LD$_2$, PT) pour produire un signal d'arrêt lorsque le panier a atteint une position voulue,

un circuit de commande électronique (TR$_1$, TR$_2$, C$_1$, C$_2$ ; R$_3$, R$_4$ ; LD$_1$) connecté aux moyens détecteurs électriques (LD$_2$, PT) et audit moyen commutateur actionnable manuellement (P), pour arrêter le moteur électrique (M) du panier en réponse audit signal d'arrêt et pour empêcher toute autre activation dudit moteur électrique (M) avant que ledit moyen commutateur électrique actionnable manuellement (P) n'ait été désactivé ; et en ce que le dispositif est arrangé de façon à être actionnable lorsque la porte de la machine est fermée.

2. Dispositif selon la revendication 1, caractérisé en ce que ledit circuit de commande électronique (TR$_1$, TR$_2$, C$_1$, C$_2$ ; R$_3$, R$_4$ ; LD$_1$) est connecté auxdits moyens détecteurs (LD$_2$, PT), au moyen commutateur (P) et au régulateur électronique de vitesse (SR) et en ce que il est capable d'être mis

dans un premier état stable en réponse à l'activation dudit moyen commutateur (P) pour permettre l'arrêt du moteur (M), et

dans un second état stable en réponse audit signal d'arrêt, dans lequel il empêche toute autre activation dudit moteur électrique (M) avant que le moyen commutateur (P) n'ait été désactivé.

3. Dispositif selon la revendication 1 ou 2, caractérisé en ce que lesdits moyens détecteurs comprennent un dispositif photo-émetteur électrique (LD$_2$) un dispositif connecté au panier pour intercepter le faisceau lumineux et un dispositif électrique photosensible (PT).

4. Dispositif selon l'une quelconque des revendications précédentes, caractérisé en ce que qu'il comprend également un indicateur optique (LD$_1$) devant être active lorsque le panier est arrêté.

5. Dispositif selon l'une quelconque des revendications précédentes, caractérisé en ce que qu'il comprend une résistance (R$_3$) connectée à un condensateur électrique (C$_2$) de façon à former un circuit intégrateur pour introduire un retard prédéterminé entre ledit signal d'arrêt et la désactivation du moteur (M) qui entraîne le panier.

6. Dispositif selon la revendication 4 ou 5, caractérisé en ce que l'alimentation électrique dudit indicateur optique (LD$_1$) est commandée par lesdits moyens détecteurs (LD$_2$, PT) ; les moyens détecteurs produisant, l'interruption de l'alimentation électrique de l'indicateur optique (LD$_1$) lorsque le panier a atteint ladite position prédéterminée.

7. Dispositif selon la revendication 6, caractérisé en ce que ledit dispositif photo-émetteur électrique est une diode électroluminescente ($LD_2$) et en ce que ledit dispositif électrique photosensible est un photo-transisteur (PT) couplé à la diode électroluminescente ($LD_2$).

8. Dispositif selon la revendication 6, caractérisé en ce que, pour commander l'alimentation dudit indicateur optique ($LD_1$), un transistor ($TR_1$) dont l'électrode de commande est connectée à la sortie desdits moyens détecteurs ($LD_2$, PT) est utilisé pour désactiver ou activer l'alimentation de l'indicateur optique ($LD_1$) selon que le panier a ou non déjà atteint ladite position prédéterminée après que ledit moyen commutateur actionnable manuellement (P) ait été activé.